# EUROPEAN PATENT APPLICATION

(11) **EP 1 983 548 A1**
(43) Date of publication of application: **22.10.2008**
(21) Application number: 07008107.0
(22) Date of filing: 20.04.2007
(51) Int. Cl.: H01J 37/073, H01J 37/18, H01J 7/18

(54) **Emitter chamber, charged particle apparatus and method for operating same**

(71) Applicant: ICT Integrated Circuit Testing Gesellschaft für Halbleiterprüftechnik mbH, 85551 Heimstetten (DE)
(72) Inventor: Adamec, Pavel, 85540 Haar (DE); Zhou, Fang, 85622 Feldkirchen (DE)
(74) Representative: Zimmermann, Gerd Heinrich

(57) **Abstract**

An emitter chamber (100) for a charged particle beam apparatus (500) with a wall (510, 515) defining a vacuum enclosure is provided, the emitter chamber (100) comprising a housing (110, 114) enclosing an emitter (120) and at least one pump (130), and attachment means (116) for attaching said emitter chamber (100) to the wall (515) of said charged particle apparatus (500) so that the housing (110, 114) of said emitter chamber is accommodated within said vacuum enclosure.

## Description

### FIELD OF THE INVENTION

The invention relates to an emitter chamber of a charged particle apparatus, a charged particle apparatus and a method for operating such a charged particle apparatus.

### BACKGROUND OF THE INVENTION

Technologies like microelectronics, micromechanics and biotechnology have created a high demand in industry for structuring and probing specimens within the nanometer scale. On such a small scale, probing or structuring, e.g. of photomasks, is often done with electron beams which are generated and focused in electron beam devices like electron microscopes or electron beam pattern generators. Electrons beams offer superior spatial resolution compared to e.g. photon beams due to their short wave lengths at a comparable particle energy.

The first step in the process of creating images in any electron microscope is the production of an electron beam. The electron beam is generated in a device often called an electron gun. Three major types of electron guns are used in electron microscopes: tungsten-hairpin filament guns, lanthanum-hexaboride guns, and field-emission guns. Field-emission guns offer several advantages over tungsten-hairpin filament guns or lanthanum-hexaboride guns: First, the brightness may be up to a thousand times greater than that of a tungsten gun. Second, the electrons are emitted from a point more narrow than that in the other sources. Thus, superior resolution is achieved by field-emission guns compared to tungsten or LaB₆ guns. Furthermore, the energy spread of the emitted electrons is only about one-tenth that of the tungsten-hairpin gun and one-fifth that of the LaB₆ gun. Finally, the field-emission gun has a very long life, up to a hundred times that of a tungsten gun. For these reasons, the field-emission gun is the preferred choice for a number of applications.

There exist three major types of field emission guns: cold field emission guns, thermal field emission guns and Schottky emitters. While cold field emission guns rely on the pure field emission effect, thermal field emission guns enhance the pure field emission effect by giving some thermal energy to the electrons in the metal, so that the required tunneling distance is shorter for successful escape from the surface. A Schottky emitter is a thermal field emitter that has been further enhanced by doping the surface of the emitter to reduce the work function.

The cold field emitter tip has the highest brightness of presently known emitters and is therefore the preferred choice for obtaining highest possible electron density in the smallest spot. Thus, electron microscopes equipped with cold cathode emitters are superbly suited to obtain high resolution, high quality images - especially at very low acceleration voltages. Extra advantages of cold emitters are their long lifetime and ease of use, which reduces the cost of ownership.

However, during operation continual adsorption and occasional desorption of residual gas molecules occurs on the emitting surface of cold field electron emitters. These adsorptions and desorptions lead to continuously degraded and momentarily instable emission current, respectively, so that the emitting surface has to be cleaned in regular intervals. Conventionally, this is done by a so-called "flashing" method. According to the flashing method, a heating current is supplied to the emitter so that the emitting surface heats up and the debris is removed from the surface. Heating the tip momentarily (flashing) can clean it, but new atoms and molecules quickly readsorb even in the best of vacuums. In addition, atoms may be ionized by the electron beam and subsequently accelerated back into the tip, causing physical sputtering of the tip itself. To minimize the current fluctuations, the electron source must be operated in a high vacuum environment.

Therefore, vacuum sensitive electron emitters like cold field emitters are usually placed in an ultra-high vacuum chamber. Typically, the UHV chamber is pumped by an ion getter pump or a passive getter pump. This conventional configuration achieves vacuum levels in the range of 10⁻¹¹ Torr. However, it is very difficult to achieve better vacuum, i.e. a lower pressure level, due to the finite leak rate of the vacuum gaskets and mainly due to the diffusion of hydrogen from the chamber walls. In order to reduce the hydrogen diffusion to a sufficient degree, the chamber would have to be baked at high temperatures in the range from 500°C up to 1000°C. This, however, is not practical. Also, there exists no practical solution for increasing the pumping speed significantly higher than a few hundred liters per second. Further to hydrogen diffusion and vacuum leaks, the emission from the emitter itself as well as the bombardment of the extractor and anode deteriorate the vacuum level near the emitter tip.

It is therefore an object of the present invention to overcome at least partially the disadvantages associated with the prior art as they have been explained above.

### SUMMARY OF THE INVENTION

This object is solved by an emitter chamber according to claim 1, a charged particle apparatus according to claim 23, and an operating method according to claim 26.

Further advantages, features, aspects and details of the invention are evident from the dependent claims, the description and the accompanying drawings.

According to a first aspect of the present invention an emitter chamber for a charged particle beam apparatus is provided. The charged particle apparatus has a wall defining a vacuum enclosure and the emitter chamber includes a housing enclosing an emitter and at least one pump, and attachment means for attaching the emitter chamber to the wall of the charged particle apparatus. The attachment means are adapted so that the housing of the emitter chamber can be accommodated within the vacuum enclosure of the charged particle apparatus.

The above-described emitter chamber can be realized as a relatively small chamber. During operation, at least a major part of the small emitter chamber is surrounded by the vacuum within the charged particle apparatus. Thus, it is possible to bake the emitter chamber at high temperatures reaching 1100°C. At such temperatures, hydrogen and other gases are released not only from the surface of the chamber housing but also from the bulk of all metal parts within the chamber. Since the small interior volume of the emitter chamber can be evacuated by the internal pump provided inside the chamber, the vacuum level within the interior of the emitter chamber can be significantly improved. Especially, the hydrogen diffusion can be reduced since it is possible to bake the emitter chamber at high temperatures in the range from 500°C up to 1100°C. Thus, extreme ultra-high vacuum levels of 10⁻¹³ Torr or better can be achieved near the emitter. As a result, the contamination of the emitter tip is significantly reduced and the stability and quality of the emission current is improved.

According to an embodiment of the present invention, the housing is completely surrounded by said vacuum enclosure. In an exemplary embodiment, the attachment means are adapted to hold the housing in a spaced relation from the wall.

In this embodiment, the emitter chamber has no direct wall or interface to atmospheric pressure. Thus, practical limitations of heating the chamber to high temperatures are reduced. In particular, less heating power is required and also oxidation problems are avoided.

According to another embodiment of the present invention, the attachment means are made of a thermally isolating material. Thus, the thermal isolation of the emitter chamber is further enhanced.

According to another embodiment of the present invention, the at least one pump is an ion getter pump. According to a further embodiment of the present invention, the at least one pump is a non-evaporable ion getter (NEG) pump.

Effective getter pumps can be realized even with small dimensions. For example, even a small NEG pump can achieve a pumping speed as high as 200 liters per second. With such high pumping speeds, the small interior volume of the emitter chamber can be efficiently evacuated.

According to a further embodiment of the present invention, the NEG pump is formed as a coating of NEG material on an inside surface of said housing. Typically, the NEG coating includes a material like TiZrV or TiV. According to another typical embodiment, an overlayer including Pt, Pd or PdAg may be disposed on the NEG coating.

An NEG coating makes use of the large internal surface area of the chamber housing and an extra pump device may be omitted. Thus, the overall volume of the emitter chamber may be further reduced. In addition, the NEG coating blocks or reduces the diffusion of gas from the bulk of the housing material into the interior space of the chamber. Thus, the vacuum level inside the emitter chamber is further enhanced. Typically, NEG coatings made of TiZrV or TiV may undergo numerous cycles of repeated activation without losing their pumping capability. For example, such NEG coatings may undergo more than 50 activation/pump cycles without any noticeable deterioration of the pumping speed. Furthermore, an overlayer of Pt, Pd or a PdAg alloy can improve the pumping speed for H₂ molecules. In particular, Pt, Pd or PdAg films have high sticking probabilities for H₂ molecules but only relatively low binding energies both for surface adsorption and for solid solution. However, since the overlayer is coated on the NEG film the hydrogen can migrate through the overlayer to the NEG film where it may be stored with a negligibly low dissociation pressure.

According to a different embodiment of the present invention, the emitter chamber may further include a heater. According to a typical embodiment, the heater is accommodated within the housing. In one example, the heater may be integrally formed with the at least one pump. In another example, the heater may be integrally formed with the housing.

Thus, the heater can be readily adapted for the heating the emitter chamber to high temperatures in the range of 500°C to 1100°C. In particular, if the heater is located near the emitter chamber, inside the emitter chamber or is integrated into the emitter chamber walls, the required heating power is reduced.

According to another embodiment of the present invention, at least one differential pressure aperture is formed in the housing of the emitter chamber. According to a typical example, the volumetric flow rate through the at least one differential pressure aperture is at least one order of magnitude smaller than the pumping speed of the at least one pump.

Since some noble gases are not sufficiently pumped by some types of pumps, e.g. NEG pumps, it is an option to provide the differential pressure aperture for discharging such noble gases from the interior space of the emitter chamber into the vacuum enclosure volume of the charged particle beam apparatus. Thus, the noble gases can be pumped by suitable pumps attached to the charged particle beam apparatus. Typically, the size of the differential pressure aperture is such that a differential pressure between the interior and exterior of the emitter chamber can be maintained. In particular, the differential pressure aperture is adapted that a volumetric flow rate therethrough is smaller than the pumping speed inside the emitter chamber. Thus, the vacuum around the emitter tip can be maintained at a higher level compared to the vacuum level of the beam column.

According to another embodiment of the present invention, the emitter chamber includes at least one valve for establishing fluid communication between an interior space and an exterior space of the housing.

Such a valve may be opened during initial pump down of the charged particle apparatus and/or during activation of the internal pump inside the emitter chamber. Due to the increased volumetric flow rate from the interior of the chamber into the internal volume of the charger particle beam apparatus, the pump down time can be considerably reduced.

According to one embodiment of the present invention, the housing is adapted to serve as an extractor electrode for the emitter. According to an alternative embodiment of the present invention, an extractor electrode is accommodated within the housing of the emitter chamber. According to a further embodiment, an anode may be accommodated within the housing. Also, a suppressor electrode for the emitter may be disposed within the emitter chamber. In a typical embodiment of the present invention, the emitter is a cold field emission gun.

According to another aspect of the present invention, a charged particle beam apparatus is provided. The charged particle beam apparatus includes an emitter chamber of a configuration described above. Typically, the emitter chamber is attached to a wall of the charged particle beam apparatus.

During operation of such a charged particle beam apparatus, at least a major part of the small emitter chamber is surrounded by the vacuum within the vacuum enclosure. Thus, it is possible to bake the emitter chamber at high temperatures reaching up to 1100°C. At such temperatures, hydrogen and other gases are released not only from the surface of the chamber housing but also from the bulk of all metal parts within the chamber. Since the small interior volume of the emitter chamber can be evacuated by the internal pump provided inside the chamber, the vacuum level within the interior of the emitter chamber can be significantly improved. Especially, the hydrogen diffusion can be reduced since it is possible baked the emitter chamber at high temperatures in the range from 500°C up to 1100°C. Thus, extreme ultra-high vacuum levels of 10⁻¹³ Torr or better can be achieved near the emitter. As a result, the contamination of the emitter tip is significantly reduced and the stability and quality of the emission current is improved.

According to another embodiment of the present invention, the charged particle apparatus may further include an isolation for thermally isolating the emitter chamber from a portion of a wall of the charged particle beam apparatus. Thus, practical limitations of heating the chamber to high temperatures are reduced. In particular, less heating power is required and also oxidation problems are avoided.

According to a typical embodiment of the present invention, the charged particle beam apparatus further includes at least one pump for evacuating an internal space of a vacuum enclosure defined by the wall of the charged particle beam apparatus.

According to another aspect of the present invention, a method for operating a charged particle apparatus is provided. The method includes the steps of evacuating an interior space of the charged particle apparatus with at least one pump, heating an emitter chamber accommodated within the interior space to release gas from a housing of the emitter chamber, and evacuating an interior space of the emitter chamber with at least one pump enclosed by the housing.

By operating a charged particle apparatus according to the above method, contamination of the emitter tip can be significantly reduced and the stability and quality of the emission current can be improved. Especially, the hydrogen diffusion can be reduced since it is possible to bake the emitter chamber at high temperatures. Furthermore the small interior volume of the emitter chamber can be evacuated by the internal pump provided inside the chamber so that the vacuum level within the interior of the emitter chamber can be significantly improved. Thus, extreme ultra-high vacuum levels of 10⁻¹³ Torr or better can be achieved near the emitter.

In a typical embodiment, the interior space of the charged particle beam apparatus is evacuated to a vacuum level in the order of 10⁻¹⁰ Torr to 10⁻¹¹ Torr. According to a further embodiment, a valve may be opened during this evacuating step to establish fluid communication between the interior space of the emitter chamber and the interior space of the charged particle apparatus. Furthermore, the valve may be closed prior to evacuating the interior of the emitter chamber with the pump disposed within the chamber. Typically, the interior space of the emitter chamber is evacuated to a vacuum level in the order of 10⁻¹³ Torr. According to another embodiment of the present invention, the housing of the emitter chamber is heated to a temperature in the range from 500°C to 1100°C.

### BRIEF DESCRIPTION OF THE DRAWINGS

Some of the above indicated and other more detailed aspects of the invention will be described in the following description and partially illustrated with reference to the figures. It will be understood by those skilled in the art that the drawings are not to scale. In the drawings:
- Fig. 1: shows an emitter chamber according to an embodiment of the present invention.
- Fig. 2: shows an emitter chamber according to another embodiment of the present invention.
- Fig. 3: shows an emitter chamber according to still another embodiment of the present invention.
- Fig. 4: shows an emitter chamber according to a further embodiment of the present invention.
- Fig. 5: shows an emitter chamber according to still a further embodiment of the present invention.
- Fig. 6: shows an emitter chamber according to even another embodiment of the present invention.
- Fig. 7: shows an emitter chamber according to a different embodiment of the present invention.
- Fig. 8: shows an emitter chamber according to still a different embodiment of the present invention.
- Fig. 9: shows an emitter chamber according to an embodiment of the present invention.
- Fig. 10: shows a cross-sectional view of a coating applicable in the embodiment shown in Fig. 9.
- Fig. 11: shows an integrated heater according to an embodiment of the present invention.
- Fig. 12: shows a charged particle beam apparatus according to an embodiment of the present invention.

### DETAILED DESCRIPTION OF THE DRAWINGS

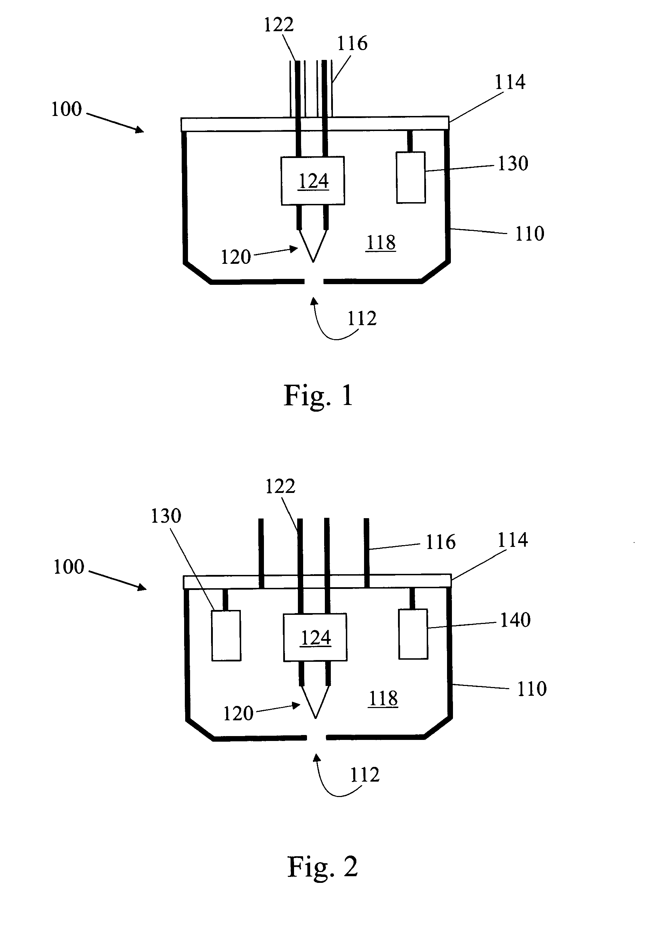

Fig. 1 shows an emitter chamber according to an embodiment of the present invention. In the following, the present invention will be exemplified by means of a cold field emission gun. However, it will be understood by those skilled in the art that the present invention may also be executed with other types of emitters. Accordingly, the cold field emission gun should only be understood as a non-limiting example of emitters that may be used with the present invention. A cold field emitter 120 is mounted inside the emitter chamber 100. Electrical power can be supplied to emitter tip 120 by means of electric feed throughs 122. As in the conventional configuration, emitter tip 120 is mounted on a ceramic support 124. Emitter chamber 100 further includes a housing defining an internal volume 118. The chamber housing includes a bottom plate 114 and a sidewall 110. The bottom plate 114 may be made of ceramic material so that electric feed throughs may be formed easily therein. Typically, sidewall 110 has a cup-like shape with an aperture 112 in its bottom. Aperture 112 is located in front of emitter tip 120 so that a beam of charged particles, e.g. electrons, emerging from emitter tip 120 can pass through aperture 112 to enter the exterior of chamber 100. In some embodiments of the present invention, e.g. the embodiment shown in Fig. 1, sidewall 110 is adapted to act as an extractor electrode for emitter 120. Therefore, sidewall 110 can be made of an electrode material, e.g. stainless steel, and can have electric terminals (not shown) to apply a specific voltage. Furthermore, at least one pump 130 is accommodated within the chamber housing 110, 114. For example, pump 130 may be an ion getter pump or a NEG pump. For example, NEG pumps are available from SAES Getters S.p.A., 20020 Lainate (Milano), Italy. Also, a combination of an ion getter pump and an NEG pump may be provided inside emitter chamber 100. Pump 130 may attain high pumping speeds in the range of 200 1/s so that the internal space of chamber 100 can be effectively evacuated by pump 130. Finally, the chamber 100 includes attachment means 116. The attachment means 116 are adapted for attaching the emitter chamber 100 to a wall portion 515 of a charged particle apparatus in manner that the chamber housing 110, 114 of the emitter chamber is accommodated within an internal space of the charged particle apparatus. In the embodiment shown in Fig. 1, attachment means 116 are formed as ducts and electric feed throughs 122 are guided within attachment means 116.

The above-described emitter chamber 100 can be realized as a relatively small chamber. In particular, only emitter 120 and pump 130 have to be accommodated within the interior space 118 of the chamber. Such a small emitter chamber 100 can be mounted within the vacuum enclosure of a charged particle beam apparatus. Typically, a charged particle beam apparatus has an outer wall defining the vacuum enclosure, also called a column. This column will be evacuated prior to operation of the charged particle beam apparatus. Typical vacuum levels that can be attained within the column are in the range of 10⁻¹⁰ Torr to 10⁻¹¹ Torr. A better vacuum cannot be attained due to leakage and outgassing as described above. Since the emitter chamber 100 is mounted inside the column, at least a major part of the small emitter chamber 100 is surrounded by the vacuum during operation of the apparatus. Thus, it is possible to bake the emitter chamber at high temperatures in the range between 500°C and 1100°C, more typically in the range from 800°C to 1000°C, without running into the problems one encounters if the gun chamber is in contact with the ambient atmosphere. At such high temperatures, hydrogen and other gases are released not only from the surface of the chamber housing 110, 114 but also from the bulk of all metal parts within the chamber. Especially, the hydrogen diffusion during operation of the emitter 120 can thus be reduced by baking the emitter chamber at high temperatures prior to operation. Since the small interior volume 118 of the emitter chamber 100 can be evacuated by the internal pump 130 provided inside the chamber, the vacuum level within the interior 118 of the emitter chamber can be significantly improved. Thus, extreme ultra-high vacuum levels of 10⁻¹³ Torr or better can be achieved near the emitter 120. In other words, a differential pressure between the interior volume 118 and the exterior of the emitter chamber can be built up during operation. As a result, the contamination of the emitter tip is significantly reduced and the stability and quality of the emission current is improved. This is especially useful in cases where emitter contamination is one of the major resolution-limiting problems like for cold field emission guns.

In the embodiment shown in Fig. 1, the attachment means 116 are adapted to hold the housing 110, 114 in a spaced relation from a column wall of the beam apparatus. Thus, the chamber 100 is completely surrounded by vacuum during operation of the beam apparatus. In other words, chamber 100 does not have any wall or interface that is in direct contact with the atmosphere but will be immersed in vacuum during operation. Therefore, problems associated with the high-temperature baking of chamber 100, e.g. oxidation, can be reduced or even completely avoided. Furthermore, in some embodiments the attachment means 116 are made of a thermally insulating material, e.g. ceramic, which further improves thermal isolation of chamber 100 and, as a result, reduces the problems associated with the high-temperature baking. Also, the better chamber 100 is thermally isolated the less heating power is required for heating the chamber.

Fig. 2 shows an emitter chamber according to another embodiment of the present invention. In this embodiment, a heater 140 is accommodated within the housing of the emitter chamber. Thus, heat can be directly transferred to the internal volume 118 of the chamber and to the chamber housing 110, 114. In contrast to an external heater, no heating power is lost when heater 140 is located inside chamber 100. Furthermore, attachment means 116 and electric feed throughs 122 are separated, i.e. electric feed throughs 122 are not guided inside attachment means 116. It will be understood by those skilled in the art that this is an alternative to the duct-like attachment means shown in Fig. 1. Of course, the skilled person may select either configuration or any other suitable configuration of attachment means 116 and electric feed throughs 122 in accordance with the requirements of a specific application.

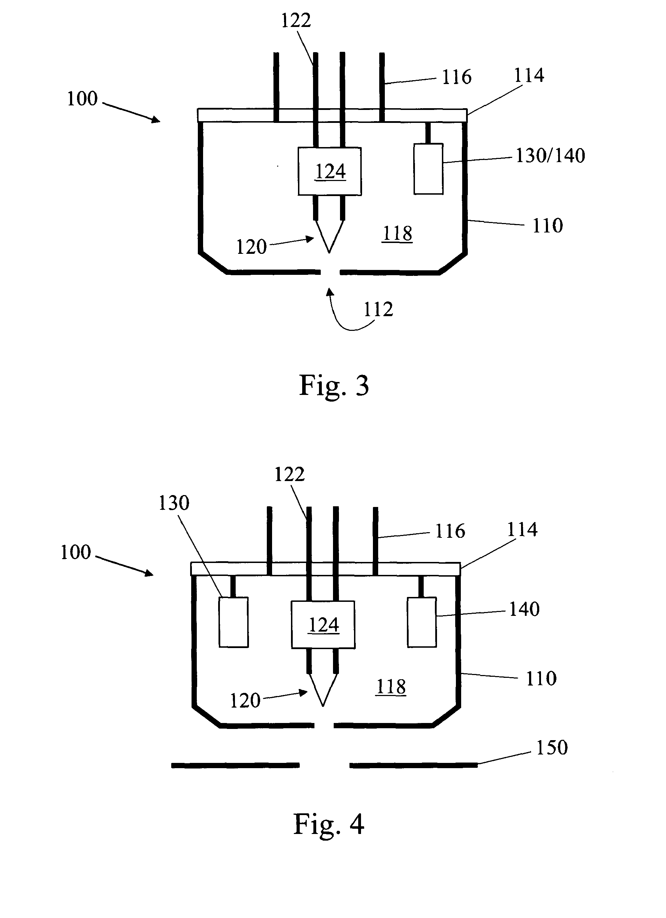

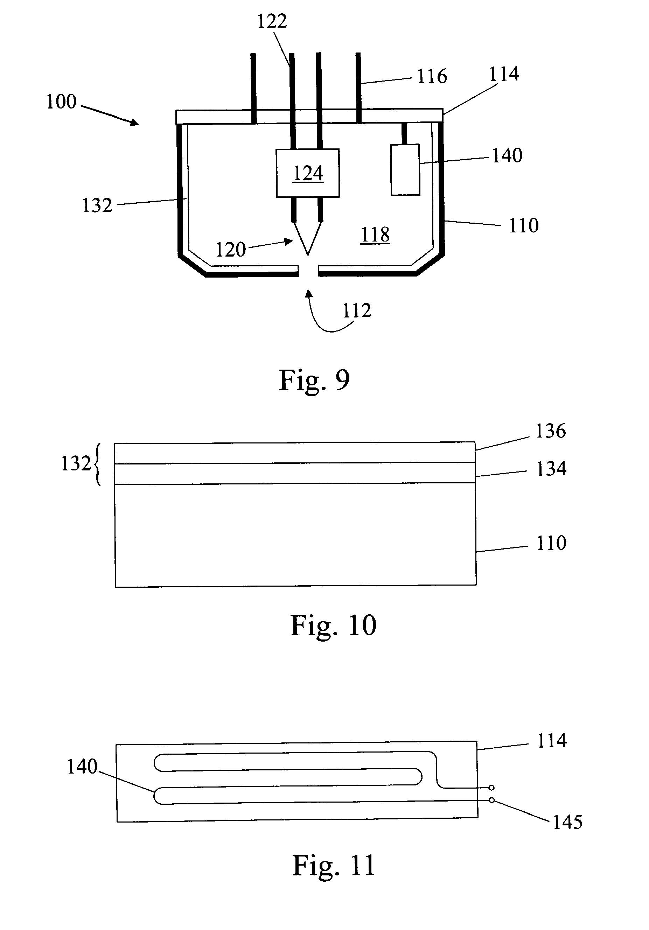

Fig. 3 shows an emitter chamber according to still another embodiment of the present invention. In this embodiment, a heater 140 is integrally formed with the pump 130. Thus, less space is consumed by the heater and the pump so that the internal volume 118 of emitter chamber 100 can be reduced. As a result, it is easier to attain a high vacuum level inside chamber 100. Also, less heating power is required for baking chamber 100 at high temperatures in the range from 500°C to 1100°C. According to an alternative embodiment shown in Fig. 11, the heater 140 may be integrally formed with the chamber housing. In the embodiment shown in Fig. 11, heater 140 is an electrical resistance heater integrated into bottom plate 114. However, it will be understood by those skilled in the art that heater 140 may additionally or alternatively also be integrated into sidewall 110 of the housing. Furthermore, electrical terminals 145 are provided to supply electric power to resistance heater 140. However, it will be understood by those skilled in the art that also other types of heaters may be used if applicable.

Fig. 4 shows an emitter chamber according to a further embodiment of the present invention. Therein, the sidewall 110 of the chamber housing does not serve as an extractor electrode. For example, sidewall 110 may be formed of an electrically insulating material. If sidewall 110 does not serve as the extractor electrode, an extractor electrode 150 may be provided outside of emitter chamber 100. Extractor electrode 150 is of a conventional design and its beam-limiting aperture is aligned with aperture 112 and emitter 120. It will be understood by those skilled in the art that extractor electrode 150 will be spaced from emitter tip 120 at such distance that field emission from emitter tip 120 can be effected by applying a suitable voltage to extractor electrode 150.

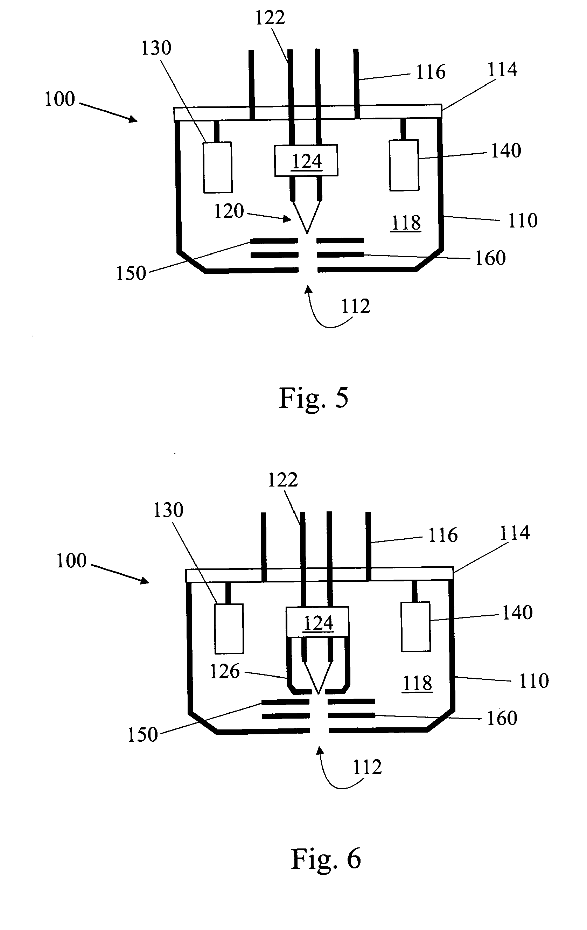

Fig. 5 shows an emitter chamber according to still a further embodiment of the present invention. Therein, an extractor electrode 150 and an anode 160 are accommodated within the housing 110, 114. In other words, the complete emitter unit, i.e. emitter 120, extractor 150, and anode 160, are disposed within the interior volume 118 of the emitter chamber 100. Thus, the emitter unit 120, 150, 160 is surrounded by the extreme ultra-high vacuum inside chamber 100. Furthermore, also the bulk metal of the electrodes 150, 160 can be baked at high temperatures so that gas, especially hydrogen, is released therefrom. Accordingly, the vacuum level inside emitter chamber 100 and especially in the vicinity of emitter 120 can be maintained at a very high level in the order of 10⁻¹³ Torr during operation. Thus, the stability of the emission current can be significantly enhanced.

Fig. 6 shows an emitter chamber according to even another embodiment of the present invention. In principle, the embodiment shown in Fig. 6 is a variation of the embodiment shown in Fig. 5. Also, in the embodiment of Fig. 6, the complete emitter unit is accommodated within emitter chamber 100. In addition, a suppressor electrode 126, also referred to as a Wehnelt cap, is provided around emitter 120. Suppressor 126 is applied in some types of emitters to focus the electrons in front of the anode. It will be understood by those skilled in the art that suppressor electrode 126 is an optional feature and may be omitted if not required.

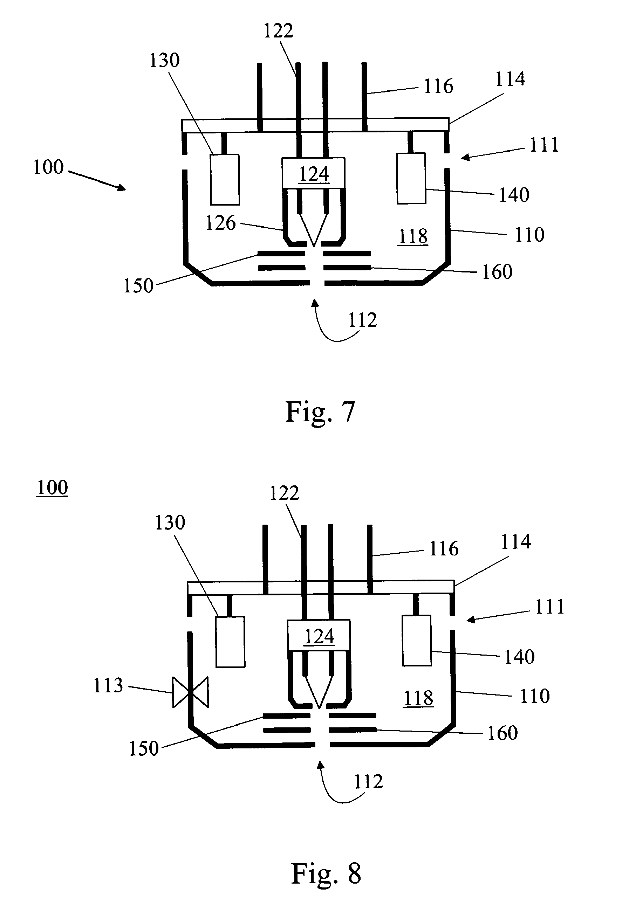

Fig. 7 shows an emitter chamber according to a different embodiment of the present invention. Therein, differential pressure apertures 111 are formed in the sidewall 110 of the chamber housing. The differential pressure apertures 111 provide fluid communication between the interior volume 118 of the chamber and a surrounding exterior space of chamber 100. However, the size of each of the differential pressure apertures 111 as well as the total area of all differential pressure apertures 111 is such that a differential pressure can be built up and maintained between the interior volume 118 and the exterior space of chamber 100. For example, the volumetric flow rate through the differential pressure aperture 111 may be one order of magnitude smaller than the pumping speed of the pump 130 within chamber 100. Thus, the pressure inside chamber 100 can be maintained one order of magnitude lower than the pressure outside the chamber. According to another example, the pumping speed of pump 130 may be about 200 liters per second. The size and number of the differential pressure apertures 111 is selected so that the total volumetric flow through these apertures is only 2 liters per second. For example, two to eight apertures 111 may be provided, each having a diameter of 1 mm to 2 mm. Thus, the volumetric flow through the differential pressure apertures 111 is two orders of magnitude lower than the pumping speed of pump 130. Accordingly, the vacuum level inside emitter chamber 100 can be maintained about two orders of magnitude higher compared to the vacuum surrounding chamber 100. For example, chamber 100 may be placed in ultra-high vacuum at about 10⁻¹¹ Torr while an extreme ultra-high vacuum of about 10⁻¹³ Torr is maintained within emitter chamber 100. The purpose of differential pressure apertures 111 is to allow noble gases to exit the interior volume 118 of emitter chamber 100. It is known by those skilled in the art that some types of pumps, e.g. NEG pumps, have no or only little capability of pumping noble gases. However, other pumps attached to the charged particle beam apparatus are capable to pump these noble gases. Therefore, the differential pressure apertures 111 allow pumping of the noble gases without significantly deteriorating the vacuum inside emitter chamber 100.

Fig. 8 shows an emitter chamber according to still a different embodiment of the present invention. In this embodiment, a valve 113 is provided in the chamber housing. The valve 113 is adapted for establishing fluid communication between the interior space 118 and an exterior space of the emitter chamber 100. Of course, there will be also control means (not shown) provided to control operation of valve 113. The purpose of valve 113 is to reduce initial pump-down time of the chamber 100. Typically, the central aperture 112 for the charged particle beam and the differential pressure apertures 111 provide only small volumetric flow between the internal volume 118 of chamber 100 and the exterior thereof. Thus, the chamber housing 110, 114 defines a partially enclosed volume 118 requiring long pump-down times to achieve a sufficient vacuum level inside chamber 100. When valve 113 is open during initial pump down, sufficient volumetric flow between the interior 118 and the exterior of chamber 100 is established so that the pump-down time is significantly reduced. When a sufficient vacuum level is reached after this initial pump down, e.g. 10⁻¹¹ Torr, the valve 113 may be closed and a differential pressure between the interior 118 of chamber 100 and the exterior vacuum can be built up by pump 130. According to further embodiments of the present invention, valve 113 and differential pressure apertures 111 may be integrally formed. In particular, it may be possible to control valve 113 to provide an aperture of varying size. Thus, a large opening for fast pump down may be provided initially and, subsequently, the aperture size may be reduced to provide a differential pressure aperture.

Fig. 9 shows an emitter chamber according to an embodiment of the present invention. In this embodiment, the pump 130 is formed as a coating 132 of NEG material on an inside surface of the chamber housing 110. Thus, the internal volume 118 of chamber 100 can be reduced compared to embodiments in which the pump is provided as an extra part. According to the embodiment shown in Fig. 9, the internal surface of the sidewall 110 is coated with a non-evaporable getter (NEG) material 132. Typical NEG materials include at least one of the materials selected from the group consisting of Ti, V, Zr, Hf, Fe or any mixture thereof. Typical examples of NEG materials include TiZrV or TiV. For example, non-evaporable getter materials are available from SAES Getters S.p.A., 20020 Lainate (Milano), Italy. Different from conventional ion getter pumps, the surface of the NEG coating is not sputtered during the pumping process so that no additional material is discharged. Therefore, risk of contaminating the emitter tip 120 is reduced compared to ion getter pumps. Furthermore, the activation temperatures of the NEG materials are considerably low, e.g., in the range from 120°C to 350°C, and more typically in the range from 180°C to 250°C. Typically, the NEG coating 132 has a thickness in the range from 1 µm to 20 µm, and more typically in the range from 4 µm to 10 µm. Such NEG coatings may undergo numerous cycles of repeated activation without losing their pumping capability. For example, a TiZrV film having a thickness of 5 µm may undergo more than 50 activation/pump cycles without any noticeable deterioration of the pumping speed. Furthermore, the NEG coating 132 blocks diffusion of gases from the bulk of housing 110 into interior volume 118. Thus, pumping capacity is provided within emitter chamber 100 and diffusion of gas from the bulk of the chamber wall is blocked. In a further embodiment (not shown), the NEG coating 132 is provided together with an ion getter pump 130 within chamber 100. Thus, the advantages of ion getter pumps and NEG pumps can be combined.

Fig. 10 shows a cross-sectional view of a coating applicable in the embodiment shown in Fig. 9. Therein, it is shown that a surface of housing 110 is coated with a pump material 132. The pump coating 132 includes a layer of NEG material 134 as described above. Further to the NEG coating 134, an overlayer 136 is coated onto the NEG film 134. Overlayer 136 includes Pt, Pd or PdAg alloy and may even consist completely of one of those materials. An overlayer made of Pt, Pd or a PdAg alloy can improve the pumping speed for H₂ molecules. In particular, Pt, Pd or PdAg films have high sticking probabilities for H₂ molecules but only relatively low binding energies both for surface adsorption and for solid solution. However, since the overlayer 136 is coated on the NEG film the H₂ can migrate through overlayer 136 to the NEG film 134 where it may be stored with a negligibly low dissociation pressure. In this context, overlayers made from PdAg alloy may be particularly useful for improving the pumping speed for H₂ molecules. For example, an alloy including 70% Pd and 30% Ag may be applied for the coating. A layer system of Pd₇₀Ag₃₀/NEG may provide easier transmission of H₂ to the underlying NEG 210 than a pure Pd film. Typically, the overlayer 136 has a thickness in the range from 0.1 µm to 2 µm.

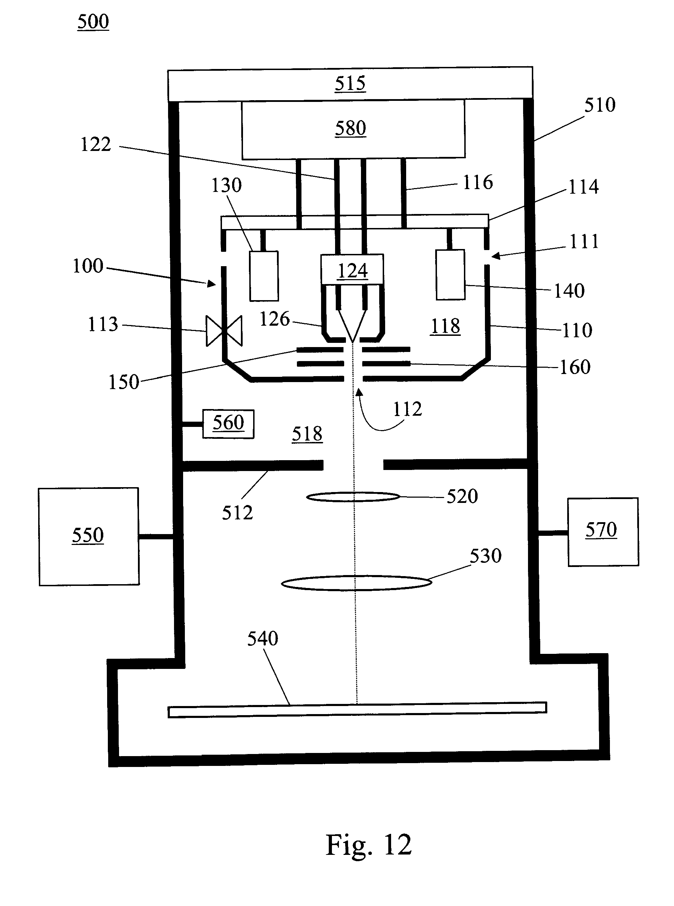

Fig. 12 shows a charged particle beam apparatus 500 according to an embodiment of the present invention. The charged particle beam apparatus 500 includes an emitter chamber 100 for producing a beam of charged particles, a condenser lens 520 and an objective lens 530 for focusing the charged particle beam onto a specimen 540. The lens system 520, 530 is of a conventional configuration and will not be explained in further detail. Furthermore, the charged particle beam apparatus includes a wall 510, 515 defining a vacuum enclosure. In other words, the interior volume 518 of charged particle beam apparatus 500 can be evacuated. For this purpose, pumps 550, 560 are provided with charged particle beam apparatus 500. Typically, there may be external pumps 550 like turbomolecular pumps attached to charged particle beam apparatus 500 and there may be also internal pumps 560 like ion getter pumps provided within charged particle beam apparatus 500. Furthermore, there may be a conventional UHV heater 570 attached to charged particle beam apparatus 500 to heat apparatus 500 at initial pump down and to activate internal NEG pumps 560. Thus, charged particle beam apparatus 500 is adapted for its internal space 518 to be evacuated to a vacuum level of about 10⁻¹¹ Torr. In the embodiment shown in Fig. 12, the emitter chamber 100 is formed according to the embodiment shown in Fig. 8. However, it will be understood by those skilled in the art that the emitter chamber may also be formed according to any of the other embodiments disclosed herein, whether shown in the drawings or only described in the text. Emitter chamber 100 is attached to a top wall or lid 515 of the charged particle apparatus by attachment means 116. In the present embodiment, attachment means 116 are not directly attached to lid 515 but to an isolation 580. Isolation 580 is adapted for thermally isolating the emitter chamber 100 from lid 515 of the charged particle beam apparatus. Thus, lid 515 can be maintained at a desired lower temperature even when chamber 100 is baked at high temperatures up to 1100°C. Although shown as a part of charged particle beam apparatus 500, isolation 580 may also be integrally formed with attachment means 116. In other words, thermal isolation 580 may be a part of the attachment means. As can be seen, attachment means 116 hold the emitter chamber 100 in a spaced relation from the wall 510, 515 of the charged particle beam apparatus 500. Accordingly, emitter chamber 100 is completely surrounded by the vacuum within charged particle beam apparatus 500. Thus, it is possible to bake the emitter chamber 100 at high temperatures reaching 1100°C. At such temperatures, hydrogen and other gases are released not only from the surface of the chamber housing but also from the bulk of all metal parts within the chamber. Since the small interior volume of emitter chamber 100 can be evacuated by the internal pump 130 provided inside the chamber, the vacuum level within the interior 118 of the emitter chamber can be significantly improved. Especially, the hydrogen diffusion can be reduced since it is possible to bake the emitter chamber at high temperatures in the range from 500°C up to 1100°C. Thus, extreme ultra-high vacuum levels of 10⁻¹³ Torr or better can be achieved near the emitter. As a result, the contamination of the emitter tip is significantly reduced and the stability and quality of the emission current is improved. Furthermore, differential pressure between the interior 118 of chamber 100 and the interior of charged particle beam apparatus 500 can be established. For example, a pressure difference of two orders of magnitude may be maintained between the emitter chamber 100 and apparatus 500. In particular, emitter 120 may be surrounded by a vacuum of 10⁻¹³ Torr or better while the rest of the beam column is at a vacuum level of about 10⁻¹¹ Torr. Due to the improved vacuum conditions near the emitter, the imaging quality of charged particle beam apparatus 500 can be significantly enhanced. In particular, the above described configuration may solve some of the problems associated with contamination of cold field emission guns.

Next, a method for operating a charged particle apparatus according to an aspect of the present invention is described. The exemplary embodiment described below refers to the charged particle beam apparatus 500 shown in Fig. 12. However, it will be understood by those skilled in the art that the method can be applied also to other embodiments of such charged particle beam apparatus including different embodiments of the emitter chamber. In a first step, the interior volume 518 defined by the vacuum enclosure 510, 515 of the charged particle beam apparatus 500 is evacuated. For this purpose, external and internal pumps 550, 560 are used in the conventional manner. As can be seen, the upper part of the column is separated by the lower part by an aperture 512. Thus, differential pressure pumping is enabled. This technique is known in the art and will therefore not be explained in more detail. In the present embodiment, valve 113 of emitter chamber 100 will be open during this initial pump down to allow for sufficient volumetric flow between the interior 118 of chamber 100 and the interior volume 518 of the charged particle beam apparatus. This initial pump down may be carried out until a maximum vacuum level, e.g. 10⁻¹⁰ Torr to 10⁻¹¹ Torr, is attained inside charged particle beam apparatus 500. It has been described above that it is very difficult to achieve better vacuum, i.e. a lower pressure level, for the interior 518 of the charged particle beam apparatus 500 due to the finite leak rate of the vacuum gaskets and mainly due to the diffusion of hydrogen from the chamber walls. When the operating vacuum level is attained, valve 113 is closed. Then, emitter chamber 100 is heated by heater 140 to very high temperatures in the range from 500°C up to 1100°C, mainly in the range from 800°C to 1000°C. At such high temperatures, gases are released from the surface and bulk of the housing material and, also, from any other metal parts inside emitter chamber 100. Especially, gases will be released from suppressor electrode 126, extractor electrode 150, and anode 160. The gases released from the housing and electrodes are pumped by internal pump 130, e.g. an NEG pump. Furthermore, gases which cannot be pumped or are only pumped at a low rate by pump 130 may be discharged from the interior 118 of chamber 100 through the differential pressure apertures 111. For example, noble gases may be discharged through differential pressure apertures 111. Thus, the interior of chamber 100 can be evacuated to a vacuum level in the order of 10⁻¹³ Torr, i.e. about two to three orders of magnitude higher than the vacuum level inside of the beam column 518. Of course, the interior 518 of charged particle beam apparatus 500 is constantly pumped during the above described procedure. Thus, gas molecules discharged through differential pressure apertures 111 will be pumped by the pumps 550, 560 attached to charged particle beam apparatus 500. Finally, when a sufficient vacuum level inside emitter chamber 100 has been reached, the emitter is operated according to a conventional manner. Due to the improved vacuum conditions near the emitter, the imaging quality of charged particle beam apparatus can be significantly enhanced. In particular, the above described method may solve some of the problems associated with contamination of cold field emission guns.

Having thus described the invention in detail, it should be apparent for a person skilled in the art that various modifications can be made in the present invention without departing from the spirit and scope of the following claims. In particular, it will be understood by those skilled in the art that different features from different embodiments may be individually combined with one another. Such combinations are explicitly included by the scope of the present invention as long as those features are not mutually exclusive.

## Claims

1. An emitter chamber (100) for a charged particle beam apparatus (500) with a wall (510, 515) defining a vacuum enclosure, the emitter chamber (100) comprising
a housing (110, 114) enclosing an emitter (120) and at least one pump (130), and
attachment means (116) for attaching said emitter chamber (100) to the wall (515) of said charged particle apparatus (500) so that the housing (110, 114) of said emitter chamber is accommodated within said vacuum enclosure.

2. The emitter chamber according to claim 1, wherein the housing (110), 114) is completely surrounded by said vacuum enclosure.

3. The emitter chamber according to claim 1 or 2, wherein said attachment means (116) are adapted to hold said housing (110) in a spaced relation from said wall (510, 515).

4. The emitter chamber according to any of the preceding claims, wherein the attachment means (116) are made of a thermally isolating material.

5. The emitter chamber according to any of the preceding claims, wherein the attachment means (116) comprise an electrical feed through (122).

6. The emitter chamber according to any of the preceding claims, wherein the at least one pump (130) is an ion getter pump.

7. The emitter chamber according to any of the preceding claims, wherein the at least one pump (130) is a non-evaporable ion getter (NEG) pump.

8. The emitter chamber according to claim 7, wherein the NEG pump (130) is formed as a coating (132) of NEG material on an inside surface of said housing (110, 114).

9. The emitter chamber according to claim 7 or 8, wherein the NEG coating (132) comprises TiZrV or TiV.

10. The emitter chamber according to claim 8 or 9, further comprising an overlayer (136) comprising Pt, Pd or PdAg and disposed on the NEG coating (134).

11. The emitter chamber according to any of the preceding claims, further comprising a heater (140).

12. The emitter chamber according to claim 11, wherein the heater (140) is accommodated within the housing (110, 114).

13. The emitter chamber according to claim 11 or 12, wherein the heater (140) is integrally formed with the at least one pump (130).

14. The emitter chamber according to claim 11 or 12, wherein the heater (140) is integrally formed with said housing (110, 114).

15. The emitter chamber according to any of the preceding claims, further comprising at least one differential pressure aperture (111) formed in said housing (110, 114).

16. The emitter chamber according to claim 15, wherein the volumetric flow rate through the at least one differential pressure aperture (111) is at least one order of magnitude smaller than the pumping speed of said at least one pump (130).

17. The emitter chamber according to any of the preceding claims, further comprising at least one valve (113) for establishing fluid communication between an interior space (118) and an exterior space (518) of the housing (110, 114).

18. The emitter chamber according to any of the preceding claims, wherein said housing (110) is adapted to serve as an extractor electrode for said emitter (120).

19. The emitter chamber according to any of the preceding claims, further comprising an extractor electrode (150) accommodated within said housing (110, 114).

20. The emitter chamber according to any of the preceding claims, further comprising an anode (160) accommodated within said housing (110, 114).

21. The emitter chamber according to any of the preceding claims, further comprising a suppressor electrode (126) for said emitter (120).

22. The emitter chamber according to any of the preceding claims, wherein said emitter (120) is a cold field emission gun.

23. A charged particle beam apparatus (500), comprising an emitter chamber (100) according to any of the preceding claims, said emitter chamber (100) being attached to a wall (515) of said charged particle beam apparatus.

24. The charged particle beam apparatus according to claim 23, further comprising an isolation (580) for thermally isolating said emitter chamber (100) from a portion of a wall (515) of the charged particle beam apparatus.

25. The charged particle beam apparatus according to claim 23 or 24, further comprising at least one pump (550, 560) for evacuating an internal space (518) of a vacuum enclosure defined by the wall (510, 515) of the charged particle beam apparatus (500).

26. A method for operating a charged particle apparatus, comprising the steps of:
(a) evacuating an interior space (518) of the charged particle apparatus with at least one pump (550, 560);
(b) heating an emitter chamber (100) accommodated within said interior space (518) to release gas from a housing (110, 114) of said emitter chamber (100);
(c) evacuating an interior space (118) of said emitter chamber with at least one pump (130) enclosed by said housing (110, 114).

27. The method according to claim 26, wherein, in step (a), the interior space (518) is evacuated to a vacuum level in the order of 10⁻¹⁰ Torr to 10⁻¹¹ Torr.

28. The method according to claim 26 or 27, wherein a valve (113) is opened during step (a) to establish fluid communication between said interior space (118) of said emitter chamber (100) and said interior space (518) of said charged particle apparatus (518).

29. The method according to claim 28, wherein said valve (113) is closed prior to step (c).

30. The method according to any of claims 26 to 29, wherein, in step (b), the housing (110, 114) of said emitter chamber (100) is heated to a temperature in the range from 500°C to 1100°C.

31. The method according to any of claims 26 to 30, wherein, in step (c), the interior space (118) of said emitter chamber (100) is evacuated to a vacuum level in the order of 10⁻¹³ Torr.

32. The method according to any of claims 26 to 31, wherein, during step (c), the interior space (518) of said charged particle beam apparatus (500) is evacuated to a vacuum level in the order of 10⁻¹⁰ Torr to 10⁻¹¹ Torr.
